# DEMANDE DE BREVET EUROPEEN

(11) **EP 4 589 641 A1**
(43) Date de publication de la demande: **23.07.2025**
(21) Numéro de dépôt: 25152173.8
(22) Date de dépôt: 16.01.2025
(51) Int. Cl.: H01L 21/56, H01L 21/78, H01L 23/31, H01L 23/00

(54) **PROCEDE DE FABRICATION DE COMPOSANTS ELECTRONIQUES**

(30) Priorité: 19.01.2024 FR 2400539
(71) Demandeur: STMicroelectronics International N.V., 1228 Plan-les-Ouates, Geneva (CH)
(72) Inventeur: FALLOURD, Ludovic, 37320 LOUANS (FR)
(74) Mandataire: Cabinet Beaumont

(57) **Abrégé**

Procédé de fabrication de composants électroniques (100) à flancs mouillables à partir d'un substrat (301) dont une première face est recouverte par des plages de connexion (107) et dans lequel sont formées des puces (103), le procédé comprenant :
- une étape au cours de laquelle une grille métallique (116), comprenant des plots de connexion (117) reliés entre eux par des barreaux (118), est brasée sur les plages de connexion (107),
- une étape au cours de laquelle une couche de résine isolante (121) est formée sur le substrat (301), la couche de résine isolante (121) entourant les plots de connexion (117),
- une étape au cours de laquelle les puces (103) sont séparées les unes des autres,
la partie latérale (117B) des plots de connexion (117) et une partie de la couche de résine isolante (121) formant les flancs (119) des composants (100).

## Description

### Domaine technique

La présente description concerne la fabrication de composants électroniques. Elle vise plus particulièrement la fabrication de composants dits à montage en surface, c'est-à-dire comportant, du côté d'au moins une face, une ou plusieurs métallisations de connexion destinées à être brasées à des plages de connexion correspondantes d'un dispositif externe, par exemple une carte de circuit imprimé ou un autre composant.

### Technique antérieure

Dans certaines applications, il existe un besoin pour des composants à montage en surface dans lesquels des métallisations de connexion destinées à être brasées à un dispositif externe s'étendent jusqu'aux flancs des composants. On parle de composants à flancs mouillables (en anglais "wettable flank"). Lors du montage du composant dans son environnement (par exemple, sur une carte de circuit imprimé), les métallisations de connexion (aussi appelées contacts électriques) sont soudées ou brasées à des pistes ou éléments métalliques correspondants côté circuit imprimé. Une partie du matériau de brasage remonte alors sur les flancs des composants, ce qui permet de mettre en oeuvre une inspection visuelle de la qualité des connexions.

Ce besoin existe par exemple dans le domaine automobile ou le domaine médical et, plus généralement, dans les domaines où l'on souhaite garantir la fiabilité des connexions électriques, une fois les circuits montés dans leur environnement.

### Résumé de l'invention

Il existe un besoin d'améliorer au moins en partie certains aspects des procédés connus de fabrication de composants électroniques à flancs mouillables.

Ce but est atteint par un procédé de fabrication de composants électroniques à flancs mouillables à partir d'un substrat dont une première face est recouverte par des plages de connexion et dans lequel sont formées des puces, le procédé comprenant :
- une première étape au cours de laquelle une grille métallique, comprenant des plots de connexion reliés entre eux par des barreaux, est brasée sur les plages de connexion,
- une deuxième étape au cours de laquelle une couche de résine isolante est formée sur le substrat, la couche de résine isolante entourant les plots de connexion,
- une troisième étape au cours de laquelle les puces sont séparées les unes des autres,
moyennant quoi des composants électroniques à flancs mouillables sont obtenus, une partie latérale des plots de connexion et une partie de la couche de résine isolante formant les flancs des composants.

Selon un mode de réalisation, lors de la première étape, la grille métallique est brasée sur les plages de connexion au moyen d'une couche de brasure déposé par une technique d'impression, de préférence par sérigraphie.

Selon un mode de réalisation, la couche de brasure est en Sn ou en un alliage d'étain, tel que SnAg ou SnAgCu.

Selon un mode de réalisation, le procédé comprend, avant la deuxième étape, une étape au cours de laquelle des tranchées sont formées dans le substrat entre les puces et dans lequel, lors de la deuxième étape, la couche de résine isolante remplit les tranchées.

Selon un mode de réalisation, après la deuxième étape, la couche de résine isolante est amincie.

Selon un mode de réalisation, le procédé comprend les étapes suivantes :
- Réaliser la première étape,
- Réaliser la deuxième étape,
- Réaliser la troisième étape.

Selon un mode de réalisation, le procédé comprend les étapes suivantes :
- Réaliser la première étape,
- Former des tranchées dans le substrat,
- Réaliser la deuxième étape,
- Retirer la partie de la couche de résine positionnée à la fois entre les plots de connexion et au-dessus des tranchées,
- Réaliser la troisième étape en amincissant la deuxième face principale du substrat jusqu'aux tranchées,
- Déposer une couche de résine additionnelle sur la deuxième face du substrat,
- Découper la résine dans les tranchées.

Selon un mode de réalisation, le procédé comprend les étapes suivantes :
- Réaliser la première étape,
- Fixer l'ensemble obtenu à la première étape sur un support comprenant une couche adhésive en collant la grille métallique sur la couche adhésive,
- Réaliser la troisième étape,
- Réaliser la deuxième étape,
- Découper la résine dans les tranchées.

Selon un mode de réalisation, entre la première étape et la troisième étape, le substrat est aminci à partir d'une deuxième face, et dans lequel une couche de résine additionnelle est déposée sur la deuxième face du substrat.

Ce but est également atteint pas un composant électronique à flancs mouillables comprenant une puce protégée par un boîtier comprenant une première face principale, des flancs et une deuxième face principale, des plots de connexion étant brasés sur des plages de connexion de la puce et une couche de résine isolante entourant partiellement les plots de connexion, une partie des plots de connexion et une partie de la couche de résine isolante formant les flancs du boîtier.

Selon un mode de réalisation, les plots de connexion sont brasés sur les plages de connexion au moyen d'une couche de brasure en Sn ou en un alliage d'étain, tel que SnAg ou SnAgCu, et dans lequel les plots de connexion sont en cuivre, éventuellement recouvert d'une couche métallique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B et la figure 1C représentent, de manière schématique et en coupe, un composant électronique à flancs mouillables selon différents modes de réalisation particulier ;
la figure 2A, la figure 2B, la figure 2C, la figure 2D et la figure 2E représentent des vues en coupe illustrant des étapes d'un procédé de fabrication d'un composant électronique à flanc mouillable selon un mode de réalisation particulier ;
la figure 3A, la figure 3B, la figure 3C, la figure 3D, la figure 3E, la figure 3F, la figure 3G et la figure 3H représentent des vues en coupe illustrant des étapes d'un procédé de fabrication d'un composant électronique à flanc mouillable selon un autre mode de réalisation particulier ;
la figure 4A, la figure 4B, la figure 4C, la figure 4D, la figure 4E et la figure 4F représentent des vues en coupe illustrant des étapes d'un procédé de fabrication d'un composant électronique à flanc mouillable selon un autre mode de réalisation particulier ; et
la figure 5 représente une variante de réalisation de la figure 4C.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un ... dans une position normale d'utilisation.

Sauf précision contraire, les expressions "environ", "approximativement", "sensiblement", et "de l'ordre de" signifient à 10 % près, de préférence à 5 % près.

Les composants électroniques trouvent des applications dans de nombreux domaines industriels, et en particulier, dans le domaine automobile ou le domaine médical.

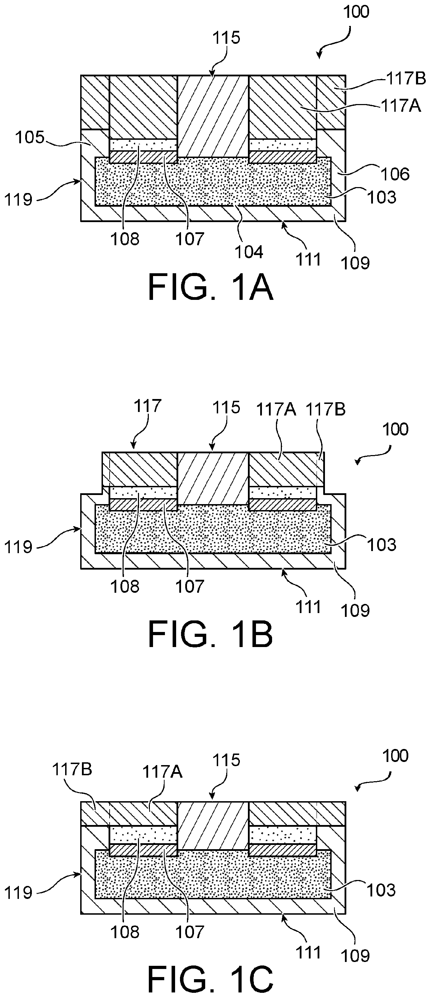

Les figures 1A, 1B, 1C illustrent, par une vue en coupe, partielle et schématique, des composants électroniques 100 selon différentes variantes de réalisation.

Le composant électronique 100 est formé d'une puce électronique 103 et d'un boîtier 109. Selon un exemple, la puce électronique 103 est formée à partir d'un substrat semiconducteur, par exemple en silicium, ou en SiC. Alternativement, le substrat peut être du verre ou du saphir.

La puce comprend une face avant 105 (aussi appelée première face ou face avant), une face arrière 104 (aussi appelée deuxième face ou face arrière) et des flancs 106 (aussi appelés faces latérales). La face inférieure 104 est opposée à la face supérieure 105.

Une ou plusieurs plages de connexion 107 (aussi appelés contacts électriques) sont formées sur la face supérieure 105 de la puce électronique 103 et permettent de la connecter à d'autres éléments (puces ou dispositifs électroniques).

Les plages de connexion électriques 107 sont aussi appelés « UBM » (pour l'expression anglo-saxonne « Under Bump Metallization ») ou parfois « pad ». Les plages de connexion électriques 107 sont en un matériau conducteur spécifiquement adapté à recevoir les plots de connexion 117, et présentant notamment une bonne adhérence avec les plots 117. Les plages de connexion électriques 107 comprennent au moins un des éléments suivants : or, titane, nickel, cuivre, argent, étain ou tungstène. De préférence, elles comprennent de l'or ou du cuivre. Les plages de connexion 107 peuvent être recouvertes d'une couche métallique (« plating »).

Les plages de connexion électrique 107 sont, par exemple, à une distance de 10 à 50 µm, voire de 10 à 30 µm de la paroi latérale de la puce. Les plages de connexion électrique 107 peuvent être positionnées sur la face supérieure 105 de la puce 103 ou affleurer la face supérieure (i.e. arriver au niveau de la face supérieure 105 de la puce 103) .

La puce 103 peut comprendre un composant discret ou plusieurs composants discrets. Le ou les composants discrets sont, par exemple, choisis parmi les transistors, diodes, thyristors, triacs, filtres, etc. La puce 103 peut comprendre un ou plusieurs circuits électroniques. La puce 103 permet de mettre en oeuvre différentes fonctions électroniques.

Le composant 100 est un composant dit intégré.

La puce 103 est protégée par le boîtier 109. Plus particulièrement, le boîtier 109 recouvre au moins la face supérieure 105. Il peut également recouvrir les flancs 106 de la puce 103 et/ou la face inférieure 106 de la puce 103.

Le boitier 109 est au moins en partie en un matériau isolant électriquement.

Pour pouvoir connecter le composant 100 à d'autres composants et/ou circuits électroniques, le boîtier 109 comprend, en outre, des plots de connexion 117 (aussi appelés contacts du boîtier ou reprises de contacts). Les plots de connexion 117 sont positionnés sur la face supérieure 105 de la puce 103. Chaque plot de connexion 117 est relié à une plage de connexion électrique 107 de la puce 103.

Les plots de connexion 117 sont formés en un matériau conducteur électriquement et "mouillable" et/ou soudable, c'est-à-dire un matériau sur lequel il est possible de réaliser un brasage ou une autre méthode de fixation mécanique (colle conductrice, frittage par exemple).

Les plots de connexion 117 sont, de préférence, en cuivre, en étain ou un de ses alliages, comme SnAgCu ou SnAg, ou un autre matériau à plus haut point de fusion. Le cuivre peut être recouvert d'une protection contre l'oxydation, comme par exemple d'une couche d'étain ou d'une couche de nickel, par placage d'étain (`Sn plating') ou placage de nickel (`Ni plating').

Les plages de connexion électriques 107 de la puce 103 et les plots de connexion 117 sont positionnés dans des ouvertures d'une couche de résine isolante 121 recouvrant la puce 103. Les plots de connexion 117 comprennent une première partie 117A soudée sur les plages de connexion 107 et une deuxième partie, dite partie latérale 117B.

La partie latérale 117B des plots de connexion 117 forme une partie des flancs 119 du composant 100 et la première partie 117A des plots de connexion 117 s'étend sur la première face principale 115 du composant 100.

Le composant 100 est un composant à flanc mouillable, c'est-à-dire qu'au moins une partie de ses flancs est formée par une couche en un matériau mouillable et soudable, c'est-à-dire un matériau sur lequel il est possible de braser. L'autre partie des flancs mouillables est en une résine isolante. La couche de matériau mouillable est formée par la partie latérale 117A des plots de connexion 117.

La partie en matériau mouillable et la couche de résine peuvent être alignées, être au même niveau (figures 1A, 1C) ou être décalées l'une par rapport à l'autre (figure 1B) .

La première partie 117A et la deuxième partie 117B des plots de connexion 117 peuvent être en un même matériau ou en différents matériaux. Ces parties 117A et 117B sont, de préférence, en un même matériau. De préférence, la première partie 117A et la deuxième partie 117B des plots de connexion 117 sont en cuivre.

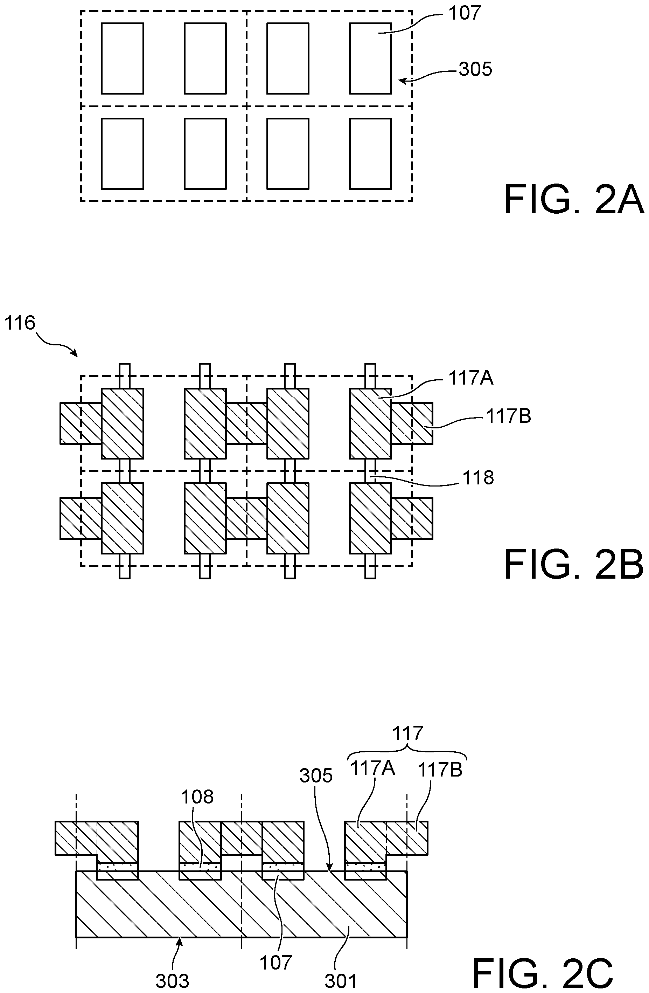

Nous allons maintenant décrire plus en détail le procédé de fabrication d'un tel composant 100 en faisant référence aux figures 2A à 2F, 3A à 3H et 4A à 4F.

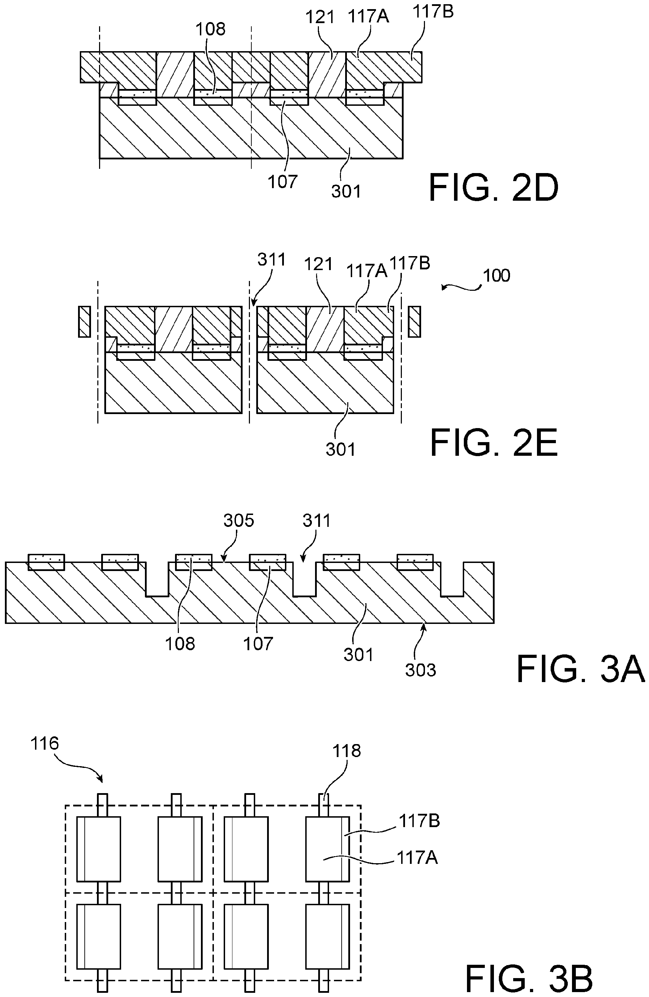

Le procédé comporte les étapes suivantes :
a) fournir un substrat 301 dont la première face 305 est recouverte par des plages de connexion 107 et dans lequel sont formées des puces (figure 2A, 3A, 4A) et fournir une grille 116 (figures 2B, 3B),
b) braser la grille sur les plages de connexion 107, au moyen d'une couche 105 de matériau brasable (figures 2C, 3C, 4B),
c) déposer une couche de résine isolante 121 sur le substrat 301, la couche de résine isolante 121 entourant les plages de connexion 107 et remplissant les espaces entre les différents éléments de la grille (figures 2D, 3D, 4D),
d) séparer les puces 103 les unes des autres (figures 2E, 3F, 4C) .

Les étapes a), b), c) et d) peuvent être réalisées dans l'ordre précité ou dans l'ordre suivant : a), b), d), c) .

A l'étape a), la fabrication du ou des composants discrets et/ou circuits intégrés formant les composants 100 est achevée. Les composants 100 sont formés à partir d'un même substrat 301, et n'ont pas encore été individualisées. Le substrat 301 comprend une première face 305 (face supérieure ou face avant) et une deuxième face 303 (ou face arrière).

Le substrat 301 est, par exemple, un substrat semiconducteur, par exemple en silicium. Il peut également s'agir de SiC.

Le substrat 301 a, par exemple, une épaisseur comprise entre 300 et 900 µm, par exemple une épaisseur d'environ 725 µm.

De plus, des plages de connexion électriques 107, décrits en relation avec les figures 1A à 1C, ont été formés sur une face supérieure 305 du substrat 301 (figures 2A, 3A, 4A) .

La grille est formée de plots de connexion 117 et de barreaux 118 connectant les différents plots 117 entre eux. Les barreaux 118 forment les lignes et les colonnes de la grille 116. Les plots 117 sont situés au niveau de l'intersection des lignes et des colonnes. Les plots 117 comprennent une première partie 117A qui va être brasée sur les plots de connexion 107 et une deuxième partie 117B qui va servir de matériau mouillable sur les flancs 119 du composant.

Les plots de connexion 117 sont reliés entre eux afin de former un réseau (grille), ce qui permet de déposer ces plots 117 sur l'ensemble du substrat simultanément. Une seule étape est nécessaire pour positionner tous les plots 117 : un gain significatif de temps est obtenu par rapport à une pose des plots 117 un par un.

En fonction de la taille du substrat 301 et de la taille de la grille 116, une grille ou plusieurs grilles peuvent être brasées sur un même substrat 301.

Lors de l'étape b), les plots de connexion 117 sont brasés sur les plages de connexion 107.

Le matériau de brasage est préalablement déposé sur les plots de connexion 107. Il peut être déposé par une technique d'impression, de préférence par sérigraphie. Il peut s'agir de toute technique de dépôt additif. Le matériau de brasage peut être en Sn, ou un alliage d'étain tel que SnAgCu ou SnAg ou un autre alliage à plus haut point de fusion.

Lors de l'étape c), une couche de résine isolante 121 est déposée sur la première face 305 du substrat 301. Elle peut être déposée par injection ('molding').

Plus particulièrement, la couche de résine isolante 121 est déposée sur la première face 305 du substrat 301 et dans les espaces de la grille. Ainsi, les plots de connexion 117 sont disposés au sein de la résine. La couche de résine isolante 121 forme une partie du boîtier 109 des composants 100 et protège donc la face supérieure des composants 100.

La résine est une résine isolante électriquement. Plus particulièrement, la résine comporte au moins un matériau de base auquel des particules isolantes électriquement sont ajoutés. Le matériau de base est choisi parmi le groupe comprenant : les résines de type époxy, et les résines de type phénolique, les résines de type acrylique. De préférence, il s'agit d'une résine de type époxy. Les particules sont, par exemple, des particules d'oxyde, et notamment des particules d'alumine ou de silice.

La résine est polymérisée, par exemple, sous rayonnement ultra-violet (UV) ou par activation thermique. Un recuit peut être réalisé après l'étape c).

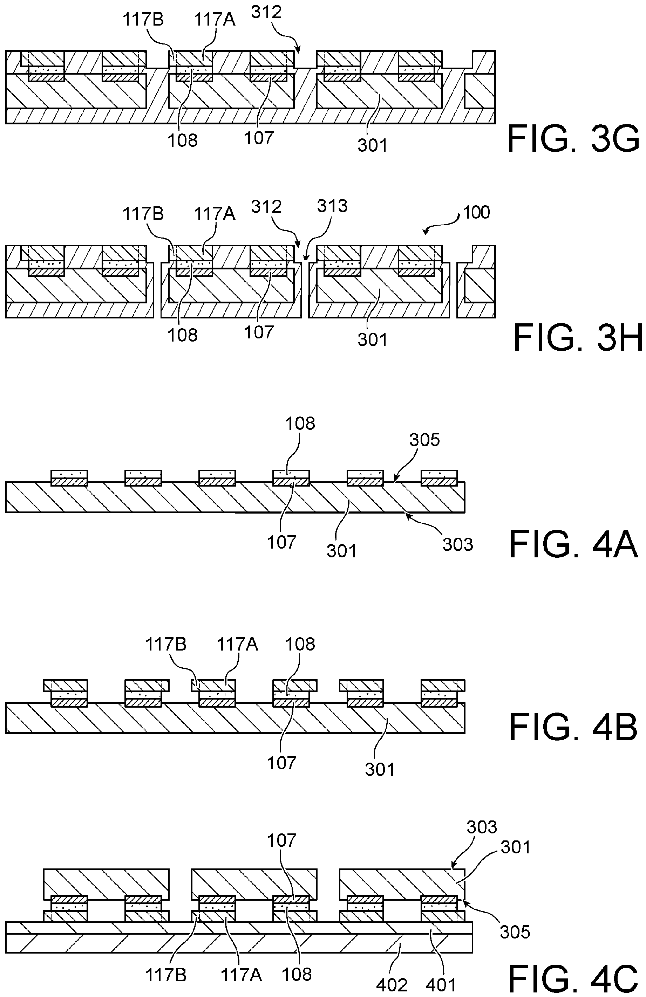

L'étape d) de séparation des puces 103 peut être réalisée en découpant le substrat 301 entre les puces 103 (figures 2E et 4C).

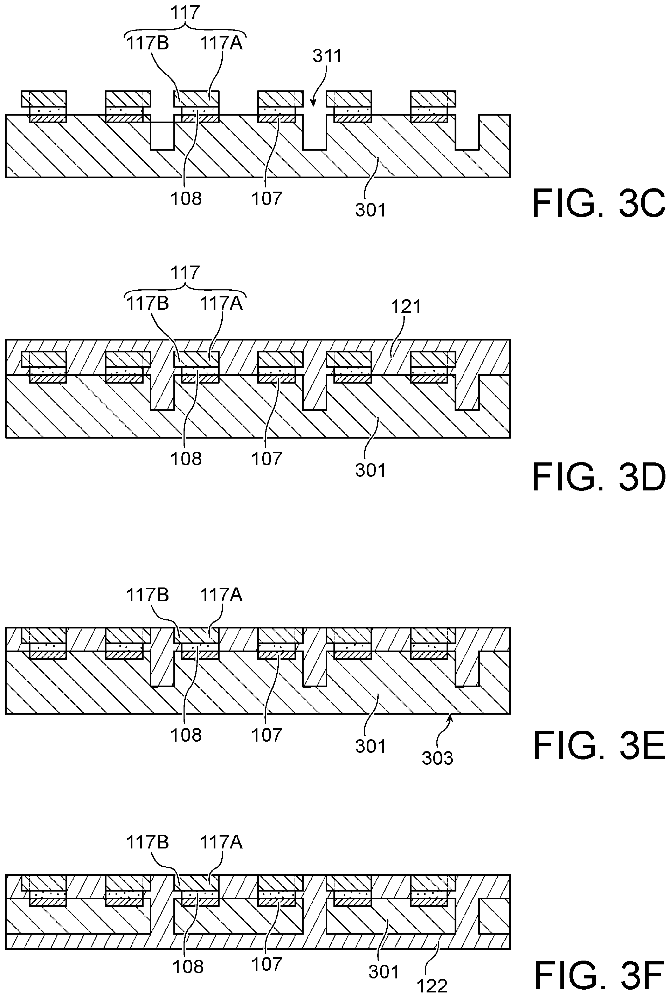

Alternativement, l'étape d) peut être réalisée en formant des tranchées 311 entre les puces 103 puis en amincissant le substrat jusqu'aux tranchées 311 (figure 3F).

La grille 116 peut être coupée à différents moments du procédé. Par exemple, elle peut être coupée pendant l'étape de formation de la tranchée, avant l'étape de formation de la tranchée, pendant l'étape de singularisation des puces, avant l'étape de formation de la couche de résine isolante ou après l'étape de formation de la couche de résine isolante, etc.

Différentes variantes de réalisation du procédé peuvent être mises en oeuvre.

Selon une première variante de réalisation représentée sur les figures 2A à 2E, le procédé comprend les étapes suivantes :
- mise en oeuvre des étapes a), b) et c) précédemment décrite (figures 2A à 2D),
- découpage du substrat 301 afin de séparer les différents composants 100 (figure 2E).

Selon cette première variante de réalisation, il est également possible de mettre en oeuvre une ou plusieurs des étapes suivantes :
- dans le cas où la résine recouvre la grille 116, amincissement depuis la face avant afin de retirer la partie de la résine isolante 121 recouvrant la grille 116 et notamment les plots de connexion 117,
- amincissement 303 de la face arrière du substrat 301,
- dépôt d'une couche de résine isolante sur la face arrière du substrat 301 pour former l'arrière du boîtier 109 des composants 100 et/ou sur les parois latérales du substrat 301.

Selon une deuxième variante de réalisation représentée sur les figures 3A à 3H, le procédé comprend les étapes suivantes :
- mise en oeuvre de l'étape a) (figures 3A et 3B), le substrat fourni à l'étape a) comprenant des tranchées 311 entre les puces,
- mise en oeuvre de l'étape b) (figure 3C),
- mise en oeuvre de l'étape c) (figure 3D),
- amincissement de la résine en face avant lorsque celle-ci recouvre la grille 116 (figure 3E),
- amincissement du substrat 301 en face arrière et dépôt d'une couche de résine pour couvrir la face arrière 303 du substrat 301 (figure 3E) ; l'étape d'amincissement étant avantageusement réalisée jusqu'à atteindre les tranchées 311, et permettant ainsi de séparer facilement les différents composants 100 ultérieurement,
- retrait de la partie de la résine positionnée à la fois au-dessus des tranchées 311 entre les plots de connexion 117, moyennant quoi les parties latérales 117B des plots de connexion 117 sont séparées par un espace 312 (figure 3G),
- découpage finale en formant une tranchée additionnelle 313 entre les composants 100 (figure 3H).

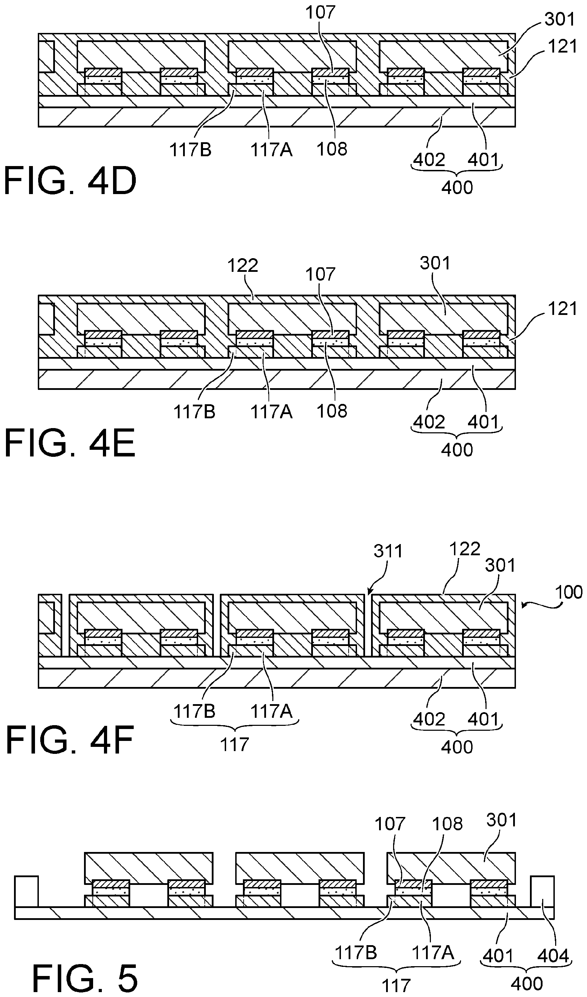

Selon une troisième variante de réalisation représentée sur les figures 4A à 4F, le procédé comprend les étapes suivantes :
- mise en oeuvre de l'étape a) (figure 4A),
- mise en oeuvre de l'étape b) (figure 4B),
- assemblage de l'ensemble obtenu à l'étape b) sur un support 400 comprenant une partie adhésive 401 et un substrat support 402 et découpage du substrat 301 afin de séparer les différents composants (figure 4C) ; l'assemblage étant réalisé en collant la grille 116, et notamment les plots de connexion 117 sur la partie adhésive 401,
- mise en oeuvre de l'étape c) (figure 4D),
- amincissement de la résine et du substrat 301 en face arrière 303 et dépôt d'une couche de résine isolante additionnelle 122 sur la face arrière 303 du substrat 301 (figure 4E),
- séparation des différents composants 100 en découpant la résine entre les composants 100 au niveau des tranchées 311 (figures 4F).

Le support 400 peut ensuite être retiré. Par exemple, un traitement UV ou un traitement thermique permet de dégrader les propriétés adhésives de la couche 401 et ainsi libérer les composants 100.

Avantageusement, le substrat support 402 est en verre.

Selon une variante, le support comprend une couche adhésive 401 et des poignées 404 (figure 5).

Dans ces différentes variantes, l'étape d'amincissement en face avant ou l'étape d'amincissement en face arrière peut être réalisée par polissage ('grinding').

L'étape d'amincissement en face arrière 303 permet d'obtenir un substrat 301 ayant son épaisseur définitive.

L'étape de formation des tranchées 311 peut être réalisée au moyen d'un dispositif de découpe. Le dispositif de découpe est, par exemple, un outil de découpe mécanique comme une scie, ou un outil de gravure par un laser. Selon un mode de réalisation préféré, le dispositif de découpe est un laser. De plus, lorsque le dispositif de découpe est un laser, la technique de découpe utilisée peut être une technique de type structuration directe par laser (LDS, « Laser Direct Structuring »).

Lors de singularisation, les composants 100 sont individualisés en réalisant une découpe entre les composants 100, par exemple au niveau des tranchées 311. Les composants 100 sont ainsi séparés les uns des autres.

La couche de résine isolante additionnelle 122 est une couche en un matériau isolant électriquement, par exemple une résine, par exemple une résine du même type que la résine de la couche 121. Selon un autre exemple, les matériaux des couches sont différents.

A l'issue du procédé, les composants 100 obtenus sont des composants à montage en surface (ou SMD pour « surface mouting device ») de type "flip-chip", c'est-à-dire qu'ils peuvent être fixés sur un dispositif externe, par exemple, une carte de circuit imprimé ou un autre composant, par leur face supérieure, c'est-à-dire la face sur laquelle sont disposés les contacts 117 du boîtier 109.

Pour cela, un matériau de brasage est positionné entre le composant 100 et le dispositif externe. Lors du brasage, le matériau de brasage remonte le long des flancs 119 des composants 100, ce qui permet de vérifier que le brasage a été réalisé correctement.

De tels composants 100 sont particulièrement intéressants pour garantir la fiabilité des connexions électriques, une fois les circuits montés dans leur environnement.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé de fabrication de composants électroniques (100) à flancs mouillables à partir d'un substrat (301) dont une première face est recouverte par des plages de connexion (107) et dans lequel sont formées des puces (103), le procédé comprenant :
- une première étape au cours de laquelle une grille métallique (116) est brasée sur les plages de connexion (107), la grille métallique (116) comprenant des plots de connexion (117) conducteurs électriquement, reliés entre eux par des barreaux (118), les barreaux (118) formant les lignes et les colonnes de la grille métallique (116),
- une deuxième étape au cours de laquelle une couche de résine isolante (121) est formée sur le substrat (301), la couche de résine isolante (121) entourant les plots de connexion (117),
- une troisième étape au cours de laquelle les puces (103) sont séparées les unes des autres,
Moyennant quoi des composants électroniques (100) à flancs mouillables sont obtenus, une partie latérale (117B) des plots de connexion (117) et une partie de la couche de résine isolante (121) formant les flancs (119) des composants (100).

2. Procédé selon la revendication 1, dans lequel, lors de la première étape, la grille métallique (116) est brasée sur les plages de connexion (107) au moyen d'une couche de brasure (105) déposé par une technique d'impression, de préférence par sérigraphie.

3. Procédé selon la revendication 2, dans lequel la couche de brasure (105) est en Sn ou en un alliage d'étain, tel que SnAg ou SnAgCu.

4. Procédé selon l'une quelconque des revendications précédentes, dans lequel, après la deuxième étape, la couche de résine isolante (121) est amincie.

5. Procédé selon l'une quelconque des revendications précédentes, dans lequel le procédé comprend, avant la deuxième étape, une étape au cours de laquelle des tranchées (311) sont formées dans le substrat (301) entre les puces (103) et dans lequel, lors de la deuxième étape, la couche de résine isolante (121) remplit les tranchées (311) .

6. Procédé selon l'une quelconque des revendications 1 à 3, comprenant les étapes suivantes :
- Réaliser la première étape,
- Réaliser la deuxième étape,
- Réaliser la troisième étape.

7. Procédé selon la revendication 5, comprenant les étapes suivantes :
- Réaliser la première étape,
- Former des tranchées (311) dans le substrat (301),
- Réaliser la deuxième étape,
- Retirer la partie de la couche de résine (121) positionnée à la fois entre les plots de connexion (117) et au-dessus des tranchées (311),
- Réaliser la troisième étape en amincissant la deuxième face principale du substrat (301) jusqu'aux tranchées (311),
- Déposer une couche de résine additionnelle (122) sur la deuxième face (303) du substrat (301),
- Découper la résine dans les tranchées (311).

8. Procédé selon la revendication 5, comprenant les étapes suivantes :
- Réaliser la première étape,
- Fixer l'ensemble obtenu à la première étape sur un support (400) comprenant une couche adhésive (401) en collant la grille métallique (116) sur la couche adhésive (401),
- Réaliser la troisième étape,
- Réaliser la deuxième étape,
- Découper la résine dans les tranchées (311).

9. Procédé selon la revendication précédente, dans lequel, entre la première étape et la troisième étape, le substrat (301) est aminci à partir d'une deuxième face (303), et dans lequel une couche de résine additionnelle (122) est déposée sur la deuxième face (303) du substrat (301).

10. Composant électronique (100) à flancs mouillables comprenant une puce (103) protégée par un boîtier (109) comprenant une première face principale (115), des flancs (119) et une deuxième face principale (111), des plots de connexion (117) conducteurs électriquement étant brasés sur des plages de connexion (107) de la puce (103) et une couche de résine isolante (121) entourant partiellement les plots de connexion (117), une partie (117B) des plots de connexion (117) et une partie de la couche de résine isolante (121) formant les flancs (119) du boîtier (109).

11. Composant électronique (100) selon la revendication 10, dans lequel les plots de connexion (117) sont brasés sur les plages de connexion (107) au moyen d'une couche de brasure (105) en Sn ou en un alliage d'étain, tel que SnAg ou SnAgCu, et dans lequel les plots de connexion (107) sont en cuivre, éventuellement recouvert d'une couche métallique.
